# EUROPEAN PATENT APPLICATION

(11) **EP 1 209 687 A2**
(43) Date of publication of application: **29.05.2002**
(21) Application number: 01127859.5
(22) Date of filing: 22.11.2001
(51) Int. Cl.: G11C 11/41, G11C 11/418, G11C 11/419

(54) **A synthesizable synchronous static RAM**

(30) Priority: 23.11.2000 IN DE105000
(71) Applicant: STMicroelectronics Ltd., Uttar Pradesh (IN)
(72) Inventor: Dubey, Prashant, Noida 201 3001, Uttar Pradesh (IN)
(74) Representative: Jorio, Paolo

(57) **Abstract**

This invention relates to a synthesizable, synchronous static RAM comprising custom built memcells and a semi-custom IO / precharge section in form of bit slice, a semi-custom built decoder connected to said bit slice and a semi-custom built control clock generation section, which is connected to said semi-custom built decoder and IO section. The arrangement being such as to provides high speed access, easy testability and asynchronous initialization capabilities while reducing design time in a size that is significantly smaller than existing semi custom or standard cell base memory design.

## Description

### Field of the invention

This invention relates to a synthesizable, synchronous static RAM for use in ASICs.

### Background of the Invention

The complexity of ASIC chips is increasing by the day. Most of the ASICs have built-in memory on them. The most common memory used on ASICs and SOC (system on chip) is Static Random Access Memory (SRAM).

There are two types of SRAMs commonly in use:
- synchronous
- asynchronous

The operations inside the asynchronous memories are not synchronized to a clock, while in synchronous memories, all operations are synchronized to a clock signal.

The SRAMs used in ASICs is optimized for high speed, low power, small areas and are synchronous in nature.

The typical known synchronous SRAM contains a data input port, an address port, a clock, a memory select port, an output enable port, a write enable port and an output port [6].

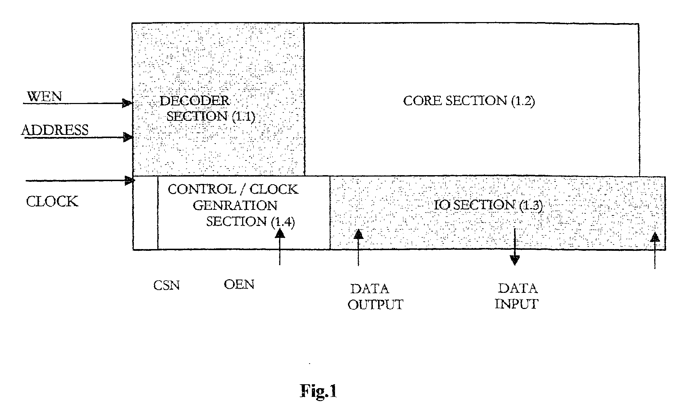

The structure of known synchronous SRAMs, is shown in fig. 1 of the accompanying drawings:
- DECODER (1.1)
- CORE (1.2)
- IO section (1.3)
- Control and clock generation circuits (1.4)
- DUMMY Paths (not shown)

All the blocks mentioned above are made in the form of bit slice cells that are abutted to form a memory block of desired word x bit configuration. The memory development activity consists of making these leaf cells in a new technology and tuning them according to the full range of words and bits required. Typically a critical path is used for the scheduling of various operations, which are triggered, by the positive edge of the external clock. This critical path is characterized on CAD tools to tune the memory for different shapes and sizes [1,5]. There are self-timing structures, which use a dummy path along the core and are triggered at the positive edge of the internal clocks (generated by the clock generation circuits). These structures are used to switch off the sense amps and intialize precharging at a suitable time (after the r/w operation has ended) [5]. This saves power consumption and decreases the cycle time of the memory [5].

Current designs of these memories have the following drawbacks:
- the memory cells are full custom blocks that do not follow the standard cell design rules and hence cannot be placed along with the Standard Cells. They are therefore, treated as hard-core macros for which separate floor planning has to be done in the layout process resulting in a long time to get ready in a particular technology.
- the testability is poor as the standard design for testability (DFT) tools treat these custom cells as Black Boxes and hence do not model internal structure.
- there is no asynchronous reset facility, due to which these memories require a long time for initialization
- typically, these memories are routed in more than three metal layers. Hence, over-the-block routing in metal in higher levels is not possible.
- the Front End models in HDL's are behavioral owing to the custom design hence the modus operandi of the memory is not clear to the user. This makes debugging of these memories difficult.

### The objects and summary of the invention

The object of this invention is to obviate the above drawbacks by providing a synthesizable synchronous static RAM using a combination of custom and semi-custom built blocks.

The second object of this invention is to improve the speed of access of the synchronous static RAM.

The third object of this invention is to provide easy testability.

Yet, another object of this invention is to provide asynchronous initialization.

Yet, another object of this invention is to provide memory modeling at the RTL level.

Further object of this invention is to enable automatic layout and thereby reduce the design time.

To achieve said objectives this invention provides a synthesizable, synchronous static RAM comprising:
- custom built memcells and a semi-custom IO / precharge section in form of bit slice,
- a semi-custom built decoder connected to said bit slice,
- a semi-custom built control clock generation section, which is connected to said semi-custom built decoder and IO section,
the arrangement being such as to provides high speed access, easy testability and asynchronous initialization capabilities while reducing design time in a size that is significantly smaller than existing semi custom or standard cell base memory design.

The said custom-built memcells in bit slice are compatible with semi-custom synthesis tools and standard cell layout design rules for simulation and automatic layout thereby reducing design time.

The said memcell and IO / precharge section in the said bit slice comprise a single column of memory cells connected to common bit lines.

The said semi custom built decoder including flip-flops at its output for prevention of any glitches arising from reaching said custom-built bit memcells, said flip flops being driven by clock tree signals to reduce clock skew and address setup time thereby improving speed of operation.

The said decoder is a fully synthesizable block for which an RTL is available.

The said semi-custom decoder includes buffers so as to improve the speed of access.

The said custom built memcells, semi-custom decoder and IO section and semi-custom clock generation circuitry are collectively and individually testable using RTL models for each unit.

The said flip flops are provided with a common asynchronous preset / clear input so as to enable simultaneous selection of all word lines and thereby all memory locations, for writing common initialization values (the value at the said Data Input Port) at all memory locations.

The said asynchronous preset / clear signal is used to provide means for asynchronous reset.

The said flip- flop can be used to select multiple word lines simultaneously thus providing a synchronous initialization through SCAN inputs.

The ODDON input means is used to provide a checker board test pattern initialization.

The said RTL code is mapped over any technology library whether high speed low power low leakage.

The said decoder is tested using Automatically generated test patterns by means of scan input.

### Brief description of drawings

The invention will now be explained with reference to the accompanying drawings.

Figure 1 shows a typical single port SRAM in known art.

Figure 2 shows the architecture of the synthesizable synchronous static RAM, according to this invention

Figure 3 shows the architecture of the address decoder block, according to this invention.

Figure 4 shows the front-end structural model of the bit slice, according to this invention.

Figure 5 shows the layout architecture of the bit slice core, according to this invention.

Figure 6 shows the area comparison between classical memory and the 3SR RAM, according to this invention.

### Detailed description

Figure 1 has already been explained.

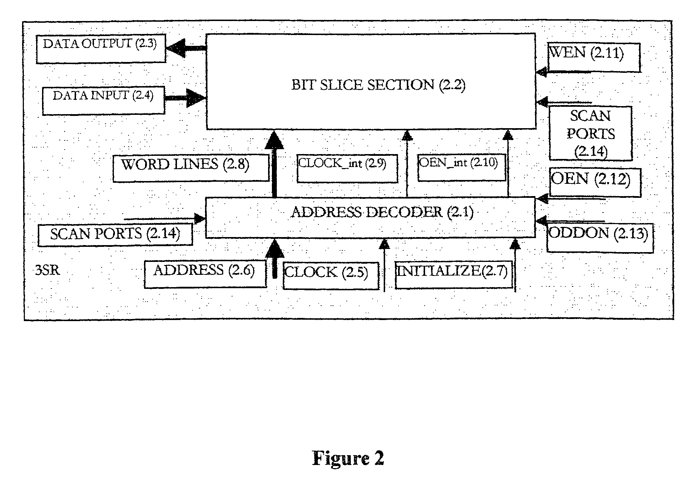

Figure 2 shows an SRAM according to this invention, which overcomes all the disadvantages of full custom SRAMs. The memory cells are full custom design organized as an array of bit slice sections (2.2). Address decoder (2.1) receives address signals (2.6) and clock signal (2.5) from external devices and generates word lines (2.8), clock-int (2.9) and OEN-int (2.10) to access the required memcell bit-slice section (2.2). Data input (2.4) received from external devices and Data Output (2.3) sent to external devices provide the data connection to the accessed memcell bit slice section (2.2). WEN (2.11) and OEN (2.12) are similarly connected to signals from external devices during write and read operations respectively. INITIALIZE (2.7) is an external signal used to initialize the bit-slice section (2.2) contents, with ODDON (2.13) being used for the special case of writing a "checkerboard" test pattern in the bit-slice section SCANPORTS (2.14) are standard scan-chain test signals for providing testability.

The Address decoder (2.1) is a semi-custom built fully synthesizable block, for which an RTL code is written. The user can map the RTL code for the memory decoder in any of the technology library anytime like high speed low leakage low power.

The custom-built memcell and a semi-custom IO precharge section in form of bit slice (2.2), semi-custom address decoder (2.1) and IO section (2.3 & 2.4) and semi custom clock generation circuitry (2.5) are collectively and individually testable using RTL models for each unit.

This RTL code is compatible with DFT insertion tools.

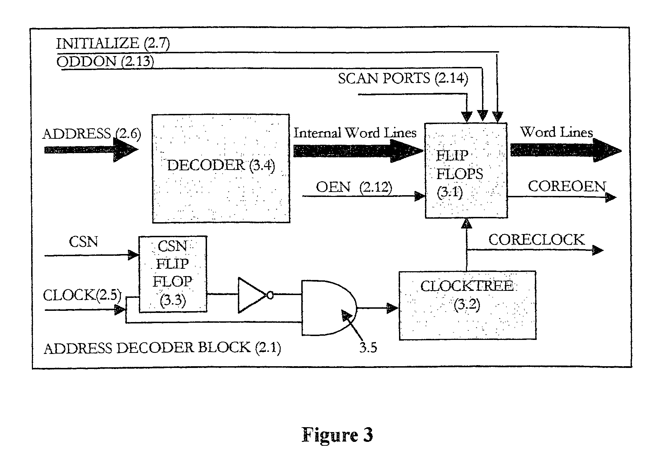

Figure 3 shows the internal structure of the semi-custom built address decoder (2.1), which decodes the address at the address ports (2.6) irrespective of the clock edge. The word lines generated at the output of Decoder (3.4) are latched in flip-flops (3.1) at the positive edge of the clock. This prevents any glitches arising at the output of Decoder (3.4) from reaching the custom-built memcells (2.2) shown in figure 2.

The semi-custom built Address decoder (2.1) includes buffers (not shown) so as to increase the speed of access. The flip flops (3.1) are provided with inputs 'INITIALIZE' (2.7) and 'ODDON' (2.13) which control the asynchronous preset / clear inputs of the flip flops so as to enable simultaneous selection of all word lines or alternate word lines respectively and thereby implement writing of a common initialization value at all or alternate memory locations. This arrangement may be used to provide an asynchronous reset function.

The clock (2.5) coming from the external devices is anded (3.5) with the output of CSN flip-flop (3.3) to reduce the power consumption when the memory has not been selected.

A clock tree (3.2) is implemented for connecting the clock to all the flip-flops (3.1) in order to reduce the clock skew. This clock tree also takes care of the clock slope at all the flip-flop inputs. The clock tree feature is optional. Although the clock tree introduces some insertion delay in the clock path, which in turn adds to the access time of the memory it simultaneously reduces the address setup time. When the clock goes negative the word lines are deselected. For dual port or multiport SRAMs similar decoder architecture can be used for different ports.

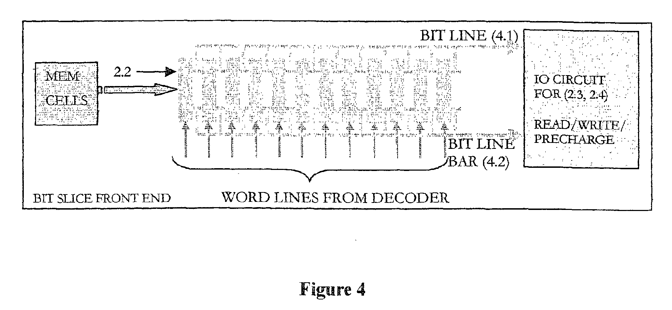

The internal arrangement of the memory cells (2.2) in bit slice form is shown in figure 4. Each bit slice is a custom built single column of memory. It has two parts: Core and IO. Core contains the memory cells (2.2) and IO (2.3 & 2.4) contains the circuitry to write or read a data into or from a memory cell, selected by the respective word line, as well as for precharging the bit lines. The memory cells in bit slice (2.2) comprising of a single column of memory cells are connected to a common bit line (4.1) and common bit line bar (4.2). The individual columns are abutted in such a way as to form a single variable bit custom cell. Each memcell in bit slice form is connected to one of the word lines coming from the address decoder (2.1). The common bit line signal is finally connected to write and read circuitry (2.3, 2.4), which is made-up of standard cells like Flip-Flops, Nand, Nor, Latches, Tristate buffers, logic buffers, logic inverters, pull-ups etc. Thus, a full structural model of a bit slice is given in the front end in which all the gates involved have clean and clear functionality, so that they do not become a black box for testability tools. The same approach be used to derive the front-end models for the dual port and multiport memories. The memory cells do not use flip-flops, as in existing designs of semi-custom /standard cell memcells, and are therefore much smaller in size.

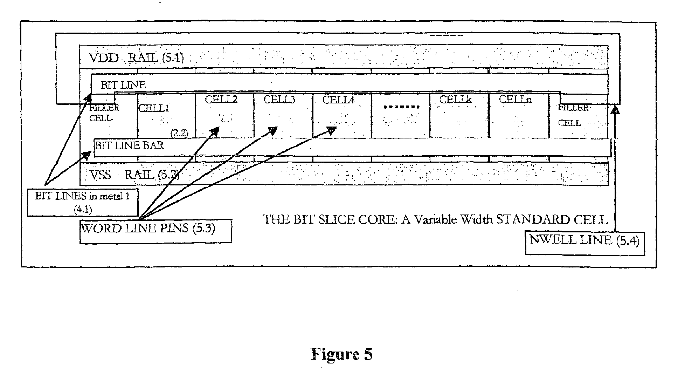

The physical layout of the memcells in bit slice form is shown in figure 5. The layouts of the custom built memcells and the gates in the IO circuitry of a single bit slice are kept abutted in such a way that they form a single variable width (depending upon the number of cells in one column) standard cell with the bit lines (4.1) running in metal 1 layer over memcells (2.2). The custom built memcells in bit slice form (2.2) are compatible with standard semi-custom simulation and synthesis tools so as to enable automatic layout thereby reducing design time. The height of each cell is equal to the height of the standard cell. The power lines, VDD (5.1) and VSS (5.2) are put in such a metal layer in which they can connect directly to the standard cell power rail, without any metal via or filler cell. To make a concise layout of the memory cell the NWELL (5.4) and other standards for a standard cell are violated in such a way that all the violations are taken care of by a filler cell put at the end and the beginning of the bit slice core. Similar architectures can be made for dual port and multiport SRAM bit slices. Therefore, the bit slice is similar to a standard cell for layout purpose and can be placed anywhere with the other standard cells. The bit lines have been kept in a lower metal layer than the word lines (5.3) to shield them against any external signal. The user can run any signal in metal 2 layer but it should be in a perpendicular direction to the bit line direction, to decrease the coupling. The bit slice IO and the bit slice CORE are kept abutted by the Unix shell routines in the place & route tool environment

The extraction of the bit line and word line capacitance is done and the delay calculated is then back annotated [2] into the memcell's front-end model in Verilog or in any other hardware description language. A point to be noted here is that the memcell in itself is a full entity which contains it's own front end model and back end (layout ) [3] and is defined as an integrated unit in order to provide bit line protection and also to achieve a good access time. Thus it does not put any limitation at the user end and a routable core is achieved through this approach. The memory characterization methodology takes care of the following facts: -
1. The bit line discharge rate for the maximum range.
2. The write margin
3. The memcell stability (SNM figure is calculated).
4. A full Monte Carlo analysis is done to check the robustness of the full bit slice to avoid any silicon failure.
5. The leakage in the bit slice core is calculated.
6. To achieve a good access time and also to take care of any setup / hold violation a constraint file is given along with the memory block to the user. This constraint file is used during the place and route of the memory.

The address decoder is synthesized and a full scan insertion [3,4] is done to make it testable. Thus, all the decoder faults can be detected through Automatic Test Program Generation (ATPG) techniques [3,4]. Besides the implementation of a testable decoder, the scan flip-flops at the word lines can be used to select more than one word line at a time (irrespective of the address at the address port). Thus, a desired pattern can be written in to the memory faster (decoding time is saved) and also in lesser clock cycles. The full memory can also be initialized through INITIALIZE and ODDON inputs. INITIALIZE also implements a synchronous (an asynchronous reset is also possible by using the Flip-Flops clear or preset pins directly) power on reset by selecting all the word lines in a single clock cycle. Similarly, when the INITIALIZE is inactive and the clock posedge comes the data word at the data port of the bit slice is written to all the odd / even addresses, depending upon whether the ODDON pin is at logic 1/0.Thus in only two clock cycles one can create a checkerboard pattern inside the memory. Other patterns can also be written into the memory in the same way. This helps in detecting the Pattern Sensitive Faults (PSF) in the memory. The advantage of this approach is that it takes lesser clock cycles to get the full coverage of the PSF's in the memory core. According to [4], faults like coupling and toggle faults are as subset of the PSF's. Hence, nearly all the faults in a memory are covered through this approach. During the Test Mode (Scan ATPG mode) the clock to all the FF's is the external CLOCK to avoid any scan design rule violation

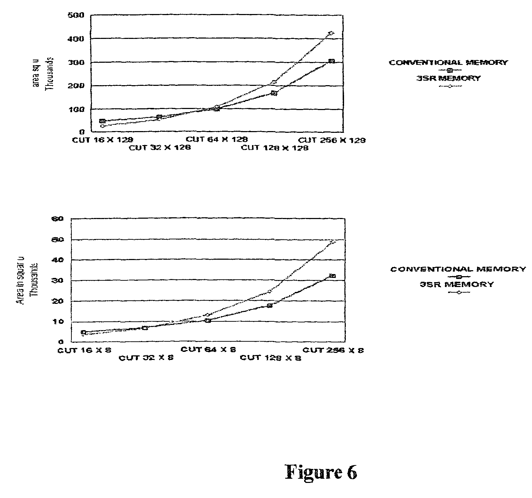

Figure 6 shows a size comparison between conventional full-custom memories and the 3SR architecture. As shown, the 3SR architecture shows an advantage for smaller configuration. In larger configurations the size penalty is only a maximum of 40%, which is very significantly less than for existing designs using semi-custom standard memcells.

### Advantages:

1. Reduction in time to market.
2. All blocks can be built using standard semi-custom DFT tools.
3. Al blocks can be placed and routed using standard automatic semi-custom layout tools.
4. The layout density is improved as the design supports routing over the memcell block.
5. There is an option of using high speed / low leakage cells any time.
6. The memory modeling is done at the RTL level and not at the behavioral level. This makes the understanding of the internal operations easy. Hence, the debugging is also easy.
7. An asynchronous initialization (including RESET) option is available, which facilitates rapid memory initialization.
8. Both synchronous and asynchronous initialization with any desired data in all locations as well as checkerboard pattern initialization are possible for testing.
9. The cell in the bit slice can be an 8/6/4/2/1 transistor static latch or it can also be a high-density cell. But in case of high-density cells, two or three cells can be accommodated in the same area with their bit lines shared. Also in case of dual or multiport memory, the cell architecture can be changed, but the basic configuration and approach remains the same.

The area overhead is only a maximum of 40 %over a full custom design. This overhead can also be reduced if a high-density memory cell is used,

### TERMINOLOGY:

FF: Flip-Flop.
ASIC: Application Specific Integrated Circuits.
RAM: Random Access Memory
SRAM: Static Ram (a volatile memory)
BIT: a unit cell of the memory into which a unit data can be written and which is supposed to store the same until the power is switched off or a new data is written to it.
WORDS: can be accessed by a particular address in a single operation cycle of the memory.
GLITCH: unwanted pulses, which can at times behave as invalid clocks and destroy the functionality of a synchronous systems.
SKEW: the phase difference in the clocks going to two or more synchronous systems that are supposed to be synchronized by a single clock.
BIST: Built In Self Test. In the present context it will mean a memory bist solution by default.

### REFERENCES:

[1] WESTE NEIL H.E., ESHRAIGHIAN KAMRAN, "PRINCIPLES OF CMOS VLSI DESIGN: Systems Perspective", ADDISON-WESLEY.
[2] Ku David C., Micheli Giovanni De, "High Level Synthesis of ASICs Under Timing and Synchronization Constraints", Kluwer Academic Publishers.
[3] Michel Petra, Lauther Ulrich, Peter Duzy, "THE SYNTHESIS APPROACH TO DIGITAL SYSTEM DESIGN", Kluwer Academic Publishers.
[4] Goor Vande A.J., "Testing Semiconductor Memories - Theory and Practice", John Wiley & Sons Ltd.
[5] HANDY JIM, "THE CACHE MEMORY BOOK", ACADEMIC PRESS, INC., Harcourt Brace & Company, Publishers.

## Claims

1. A synthesizable, synchronous static RAM comprising:
- custom built memcells and a semi-custom IO / precharge section in form of bit slice,
- a semi-custom built decoder connected to said bit slice,
- a semi-custom built control clock generation section, which is connected to said semi-custom built decoder and IO section,
the arrangement being such as to provides high speed access, easy testability and asynchronous initialization capabilities while reducing design time in a size that is significantly smaller than existing semi custom or standard cell base memory design.

2. A synthesizable, synchronous static RAM as claimed in claim 1 wherein said custom-built memcells in bit slice are compatible with semi-custom synthesis tools and standard cell layout design rules for simulation and automatic layout thereby reducing design time.

3. A synthesizable, synchronous static RAM as claimed in claim 1 wherein said memcell and IO / precharge section in the said bit slice comprise a single column of memory cells connected to common bit lines.

4. A synthesizable, synchronous static RAM as claimed in claim 1, wherein said semi custom built decoder including flip-flops at its output for prevention of any glitches arising from reaching said custom-built bit memcells, said flip flops being driven by clock tree signals to reduce clock skew and address setup time thereby improving speed of operation.

5. A synthesizable, synchronous static RAM as claimed in claim 1 wherein the said decoder is a fully synthesizable block for which an RTL is available.

6. A synthesizable, synchronous static RAM as claimed in claim 1, wherein said semi-custom decoder includes buffers so as to improve the speed of access.

7. A synthesizable, synchronous static RAM as claimed in claim 1, wherein said custom built memcells, semi-custom decoder and IO section and semi-custom clock generation circuitry are collectively and individually testable using RTL models for each unit.

8. A synthesizable, synchronous static RAM as claimed in claim 4, wherein said flip flops are provided with a common asynchronous preset / clear input so as to enable simultaneous selection of all word lines and thereby all memory locations, for writing common initialization values (the value at the said Data Input Port) at all memory locations.

9. A synthesizable, synchronous static RAM as claimed in claim 8, wherein said asynchronous preset / clear signal is used to provide means for asynchronous reset.

10. A synthesizable, synchronous static RAM as claimed in claim 8, wherein said flip- flop can be used to select multiple word lines simultaneously thus providing a synchronous initialization through SCAN inputs.

11. A synthesizable, synchronous static RAM as claimed in claim 8, wherein ODDON input means is used to provide a checker board test pattern initialization.

12. A synthesizable, synchronous static RAM as claimed in claim 5, wherein said RTL code is mapped over any technology library whether high speed low power low leakage.

13. A synthesizable, synchronous static RAM as claimed in claim 1, wherein said decoder is tested using Automatically generated test patterns by means of scan input.
